# EUROPÄISCHE PATENTSCHRIFT

(11) **EP 3 384 524 B1**
(45) Veröffentlichungstag und Bekanntmachung des Hinweises auf die Patenterteilung: **08.01.2020**
(21) Anmeldenummer: 16805356.9
(22) Anmeldetag: 28.11.2016
(51) Int. Cl.: H01L 21/48

(54) **VERFAHREN ZUM HERSTELLEN EINES VERBINDUNGSELEMENTS, VERBINDUNGSELEMENT UND SENSORANORDNUNG**
METHOD FOR THE PRODUCTION OF A CONNECTING ELEMENT, CONNECTING ELEMENT, AND SENSOR ARRANGEMENT
PROCÉDÉ DE FABRICATION D'UN ÉLÉMENT DE CONNEXION, ÉLÉMENT DE CONNEXION ET DISPOSITIF CAPTEUR

(30) Priorität: 30.11.2015 DE 102015223775
(43) Veröffentlichungstag der Anmeldung: 10.10.2018
(73) Patentinhaber: Continental Teves AG & Co. OHG, 60488 Frankfurt am Main (DE)
(72) Erfinder: HUBER, Dietmar, 63322 Rödermark (DE); RAUKOPF, Svenja, 35329 Gemünden Felda-Hainbach (DE); SCHILLINGER, Jakob, 85080 Gaimersheim (DE); THROM, Martin, 31400 Toulouse (FR)
(86) Internationale Anmeldenummer: PCT/EP2016/078998
(87) Internationale Veröffentlichungsnummer: WO 2017/093187

(56) Entgegenhaltungen:
- DE-A1-102011 056 706
- US-A1- 2001 049 161

## Beschreibung

Die Erfindung betrifft ein Verfahren zum Herstellen eines Verbindungselements, ein mittels eines solchen Verfahrens hergestelltes Verbindungselement sowie eine Sensoranordnung mit einem solchen Verbindungselement.

Verbindungselemente werden beispielsweise eingesetzt, um eine elektrische Schaltung elektrisch zu kontaktieren. Varianten einer elektrischen Schaltung lassen sich häufig durch Änderung der Beschaltung und/oder in der Abfolge der elektrischen Kontaktierung realisieren.

Beispielsweise kann ein Sensor für Magnetfelder, Beschleunigung, Drehrate, Temperatur, u.s.w. mittels unterschiedlicher Außenbeschaltung und Kontaktierungsabfolge des Steckers an die Aufgabenstellung angepasst werden.

In bekannter Weise erfolgt dies dadurch, dass unterschiedliche Unterverdrahtungsträger, hier Carrier genannt, für die verschiedenen Varianten gefertigt werden. Dies führt zu einer Großzahl von verschiedenen Konfigurationen und letztendlich zur Fertigung von kleinen Variantenstückzahlen, verbunden mit hohen Kosten sowie hohen Entwicklungs- und Qualifikationsaufwendungen.

Relevanter Stand der Technik wird beschrieben in DE 10 2011 056706 A1 (OSRAM OPTO SEMICONDUCTORS GMBH [DE]) 20. Juni 2013 (2013-06-20) und US 2001/049161 A1 (TAKAHASHI TAKEHIKO [JP]) 6. Dezember 2001 (2001-12-06).

Es ist deshalb eine Aufgabe der Erfindung, ein Verfahren zum Herstellen eines Verbindungselements vorzusehen, welches im Vergleich zu bekannten Verfahren alternativ, beispielsweise kostengünstiger durchführbar ist. Es ist des Weiteren eine Aufgabe der Erfindung, ein derart hergestelltes Verbindungselement sowie eine Sensoranordnung mit einem solchen Verbindungselement bereitzustellen.

Dies wird erfindungsgemäß durch ein Verfahren nach Anspruch 1 erreicht. Vorteilhafte Ausgestaltungen können beispielsweise den jeweiligen Unteransprüchen entnommen werden. Der Inhalt der Ansprüche wird durch ausdrückliche Inbezugnahme zum Inhalt der Beschreibung gemacht.

Die Erfindung betrifft ein Verfahren zum Herstellen eines Verbindungselements, wobei das Verbindungselement zum selektiven Herstellen elektrischer Verbindungen zwischen einer Anzahl von Eingangsanschlüssen und einer Anzahl von Ausgangsanschlüssen dient.

Mittels des erfindungsgemäßen Verfahrens ist es möglich, das Ausgangselement für eine Mehrzahl oder Vielzahl unterschiedlicher Konfigurationen auszulegen, wobei erst während des Produktionsprozesses, insbesondere während des Ausstanzens, eine Entscheidung getroffen wird, welche Verbindungen tatsächlich im Endprodukt vorhanden sein sollen. Die elektrisch leitenden Stege können dabei insbesondere als Teil des Leadframes ausgebildet sein. Dies erlaubt eine einfache Herstellung. Vorteilhaft sind sie aus elektrisch gut leitfähigem Material wie Kupfer oder Aluminium hergestellt.

Das Ausstanzen kann beispielsweise über eine Schablone und/oder einen Stempel erfolgen, dies ermöglicht eine sehr schnelle Bearbeitung. Alternativ zum Austanzen sind auch andere Verfahren zum Ausnehmen von Teilbereichen oder -abschnitten der Stege denkbar. Beispielsweise können andere Schneidverfahren zum Ausnehmen angewendet werden. Bisher hat sich das Ausstanzen aber als das vorteilhafteste Verfahren herausgestellt. Im folgenden wird die Erfindung in Verbindung mit Ausstanzen beschrieben, wobei in allgemeinerer Form auch ein Verfahren zum Ausnehmen eines Steges, Stegabschnittes, Stegteilbereiches gemeint sein kann.

Das Ausgangselement kann insbesondere eine Anzahl von Bauelementen aufweisen, welche mittels der Stege elektrisch kontaktiert sind. Dies erlaubt ein Vorsehen von bestimmten Funktionalitäten auf dem Verbindungselement.

Die Bauelemente können insbesondere ausgewählt sein aus der Gruppe, welche folgende Bauelemente aufweist:
- Kondensatoren,
- Widerstände,
- Jumper,
- Dioden,
- passive Bauelemente,
- aktive Bauelemente.

Eine Anzahl der Bauelemente kann vor dem Schritt des Ausstanzens mittels zumindest eines jeweiligen Kurzschlussstegs kurzgeschlossen sein. Dies ermöglicht ein standardmäßiges Deaktivieren des jeweiligen Bauelements. Außerdem kann es vor Stromschlägen geschützt werden.

Eine Anzahl der Kurzschlussstege kann beim Schritt des Ausstanzens ausgestanzt werden. Damit kann das jeweilige Bauelement aktiviert werden. Insbesondere können auch dessen jeweilige Anschlüsse, welche dann nicht mehr kurzgeschlossen sind, in geeigneter Weise verbunden bzw. angeschlossen werden.

Eine Anzahl der Kurzschlussstege kann auch beim Schritt des Ausstanzens nicht ausgestanzt werden. Damit bleiben die jeweiligen Bauelemente deaktiviert. Die Kombination aus ausgestanzten und nicht ausgestanzten Stegen ergibt im Ergebnis ein Verbindungselement mit einer angeforderten Schaltung.

Der Leadframe kann eine Anzahl von Dambars aufweisen. Diese können insbesondere zur Definition eines Moldkörpers verwendet werden.

Das Verfahren kann bevorzugt vor oder nach dem Schritt des Ausstanzens einen Schritt des Umhüllens der Stege bzw. zumindest eines Teils der Stege und vorzugsweise auch von Bauelementen mit einem Moldkörper aufweisen. Damit können die von dem Moldkörper umschlossenen Teile gegen mechanische und/oder chemische Beschädigung geschützt werden.

Der Moldkörper kann dabei insbesondere zumindest teilweise durch die Dambars begrenzt werden. Das Material des Moldkörpers kann dabei insbesondere bis zu den Dambars fließen. Das Material kann beispielsweise ein Thermoplast oder ein Duroplast sein.

Die Dambars können vorteilhaft beim Schritt des Ausstanzens entfernt werden.

Die Kurzschlussstege können insbesondere, ganz oder zumindest teilweise, Teil der Dambars und/oder außerhalb des eben erwähnten Moldkörpers angeordnet sein. Beispielsweise können die Kurzschlussstege, welche entfernt werden sollen, nach dem Schritt des Umhüllens mit einem Moldkörper entfernt werden, insbesondere ausgestanzt werden.

Der Leadframe kann gemäß einer vorteilhaften Ausführung eine Anzahl von Support-Pins zum Halten des Moldkörpers aufweisen.

Das Verfahren kann gemäß einer Weiterbildung nach dem Schritt des Umhüllens mit einem Moldkörper einen Schritt des Umhüllens des Moldkörpers mit einem weiteren Moldkörper aufweist. Für den weiteren Moldkörper kann gemäß einer Ausführung ein anderes Material verwendet werden als für den Moldkörper. Es kann jedoch auch das gleiche Material verwendet werden. Beispielsweise kann ein Thermoplast oder ein Duroplast verwendet werden.

Es sei verstanden, dass ebenso auch das Umhüllen mit einem dritten Moldkörper oder grundsätzlich mit einer beliebigen Anzahl von Moldkörpern möglich ist.

Es sei außerdem verstanden, dass auch andere Elemente wie z.B. ein Sensor, mit welchem das Verbindungselement elektrisch verbunden wird oder für welchen das Verbindungselement zum Anschließen dient, mit in einen jeweiligen Moldkörper mit aufgenommen werden können.

Beim Schritt des Ausstanzens kann eine jeweilige Zuordnung von Eingangsanschlüssen und/oder Ausgangsanschlüssen zu vorgegebenen Belegungen, insbesondere Versorgungsspannung (Supply), Masse (Gnd) und Ausgang (Output), erfolgen. Insbesondere können entsprechende Reihenfolgen festgelegt werden. Dies erlaubt eine einfache Anpassung beispielsweise an unterschiedliche Kundenanforderungen
Die Erfindung betrifft des Weiteren ein Verbindungselement, welches mittels eines erfindungsgemäßen Verfahrens hergestellt wurde. Dabei kann auf alle beschriebenen Ausführungen und Varianten des Verfahrens zurückgegriffen werden.

Die Erfindung betrifft des Weiteren eine Sensoranordnung. Diese weist einen Sensor sowie ein erfindungsgemäßes Verbindungselement auf, wobei der Sensor an die Ausgangsanschlüsse des Verbindungselements elektrisch angeschlossen ist.

Hinsichtlich des Verbindungselements kann auf alle beschriebenen Ausführungen und Varianten zurückgegriffen werden.

Allgemein sei erwähnt, dass sich Varianten einer elektrischen Schaltung typischerweise durch Änderung der Beschaltung und/oder in der Abfolge der elektrischen Kontaktierung realisieren lassen. In der hier vorliegenden Aufgabenstellung soll beispielsweise ein Sensor für Magnetfelder, Beschleunigung, Drehrate, Temperatur, u.s.w. mittels unterschiedlicher Außenbeschaltung und Kontaktierungsabfolge des Steckers an die Aufgabenstellung angepasst werden.

In herkömmlicher Weise erfolgt dies typischerweise dadurch, dass unterschiedliche Unterverdrahtungsträger, hier Carrier genannt, für die verschiedenen Varianten gefertigt werden. Dies führt zu einer Großzahl von verschiedenen Konfigurationen und letztendlich zur Fertigung von kleinen Variantenstückzahlen, verbunden mit einem hohen Invest, hohen Entwicklungs- und Qualifikationsaufwendungen.

Gemäß der Erfindung ist es insbesondere vorteilhaft möglich, ein Gleichteil (Neutralteil) zu fertigen, welches erst am Ende der Produktionslinie kundenspezifisch programmiert wird.

Erfindungsgemäß kann dies beispielsweise in einfacher Weise dadurch erfolgen, dass der Leadframe mit gleichen Komponenten bestückt wird und durch partielles Entfernen von Verbindungsstegen die benötigten Komponenten freigeschaltet werden oder kurzgeschlossen bleiben. In ähnlicher Weise kann die Belegung der Terminal-Abgänge durch diese partiell freigestanzten Verbindungsstege programmiert werden.

Im Gegensatz zu einer Programmierung der Terminalbelegung über Digital-Speicher ist hier eine einfache Kontrolle möglich. Zudem sind Änderungen der Speicherbelegung durch externe elektromagnetische Störfelder oder Entladungsvorgänge der Speicherzellen nicht möglich. Das so programmierte System bietet also höchste Sicherheit gegen ungewolltes Umprogrammieren. Auch die Forderung nach gleicher Bestückung ist hier erfüllt. Die Voraussetzung für ein Neutralteil ist somit erfüllt.

Weitere Merkmale und Vorteile wird der Fachmann den nachfolgend mit Bezug auf die beigefügte Zeichnung beschriebenen Ausführungsbeispielen entnehmen.

Dabei zeigen:
Fig. 1: einen Zustand vor dem Ausstanzen bzw. Schneiden,
Fig. 2: einen ersten möglichen Zustand nach dem Ausstanzen,
Fig. 3: einen zweiten möglichen zustand nach dem Ausstanzen,
Fig. 4: einen Zustand nach dem Aufbringen eines zweiten Moldkörpers,
Fig. 5: einen Zustand nach dem Vereinzeln.

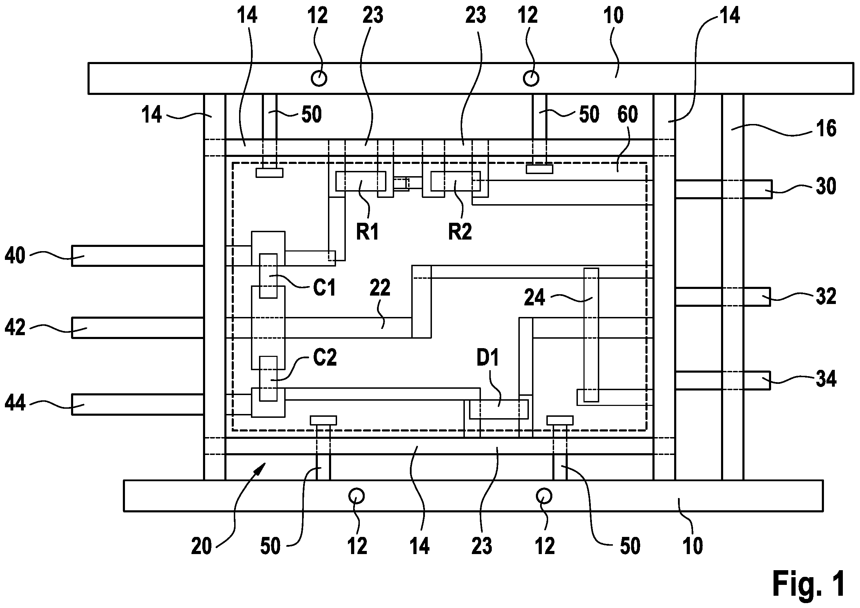

Figur 1 zeigt einen typischen Aufbau einer gemoldeten Zusatzbeschaltung als Ausgangselement 20 in einem Leadframe 10.

In dem Leadframe 10 sind eine Anzahl von Indexlöchern 12 zum Positionieren und Fixieren ausgebildet.

Das Ausgangselement 20 weist eine Mehrzahl von elektrisch leitenden Stegen 22 auf. Diese stellen elektrische Verbindungen her.

Das Ausgangselement 20 weist des Weiteren einen ersten Kondensator C1, einen zweiten Kondensator C2, einen ersten Widerstand R1, einen zweiten Widerstand R2, eine Diode D1 sowie einen Jumper 24 auf. Diese Komponenten sind hier beispielhaft gezeigt und können auch durch andere Komponenten ersetzt werden.

Das Ausgangselement 20 wird teilweise von einem Moldkörper 60 umschlossen. Dieser wird durch umlaufende Dambars 14 begrenzt. Er ist über Support-Stege bzw. Verbindungsstege 50 mit dem Leadframe verbunden.

In den Dambars 14 sind an drei Stellen Kurzschlussstege 23 ausgebildet, welche die Widerstände R1, R2 sowie die Diode D1 überbrücken bzw. kurzschließen. Durch selektives Ausstanzen dieser Kurzschlussstege 23 können die jeweiligen Bauelemente aktiviert werden. Das gleiche Prinzip wäre auch für alle anderen Arten von Bauelementen möglich.

Die Außenbeschaltung mit den Komponenten C1, C2, R1, R2, D1 und Jumper 24 stellt vorliegend eine Maximal-Bestückung dar. Eine Minderbestückung für Varianten mit hoher Stückzahl ist ebenfalls möglich. In diesem Zusammenhang können ein gleicher Leadframe 10 und ein gleich gestalteter Moldkörper 60 verwendet werden.

Anstelle der Kondensatoren C1 und C2 können beispielsweise auch Zenerdioden oder Varistoren verwendet werden, also Elemente, die eine Spannungsbegrenzung oder Spannungsbedämpfung bewirken. Die Komponenten R1, R2 und D1 dienen insbesondere zur Pegelanpassung, als Verpolungsschutz und als Schutzbeschaltung für Energieabsorption. Typischerweise sind es Widerstände und/oder Dioden.

Der vorliegend in SMD-Technik ausgeführte Jumper 24 dient vorliegend als Verdrahtungsbrücke für beispielsweise den Gnd (Masse)-Pin.

Sinnvollerweise werden als elektrisch leitende Stege 22 auch die umlaufenden Dambars 14. genutzt. Bei Low-Flash-Profilen des Moldkörpers sind jedoch beispielsweise auch abgesetzte Verbindungsstege möglich.

Die Verbindungsstege 50 fixieren den Moldkörper 60 im Leadframe 10 für nachfolgende Prozessschritte. Zusätzliche Unterstützung ist durch isolated Support-Pins möglich. Hier ist typischerweise keine Verbindung mit inneren Verdrahtungselementen zulässig.

Linksseitig in Figur 1 sind drei Ausgangsanschlüsse 40, 42, 44 ausgebildet, welche vorliegend als IC-Terminals dienen. An diese kann ein fertig abgeglichener integrierter Schaltkreis (IC) angeschweißt werden oder er wird auf einem entsprechend ausgestalteten Leadframe als Bare-Die bestückt.

Rechtsseitig in Figur 1 sind drei Eingangsanschlüsse 30, 32, 34 ausgebildet, welche vorliegend als Connector-Terminals dienen. Diese werden von einem Unterstützungssteg 16 gehalten, welcher in dem Leadframe 10 ausgebildet ist. An den Eingangsanschlüssen 16 werden beispielsweise Stecker-Pins befestigt. Die Abfolge der Belegung ist vorliegend beispielsweise Supply (30), Gnd (32), Output (34) und ist typischerweise kundenspezifisch.

Der Moldkörper 60 ist vorliegend aus einem duroplastischen Kunststoff gemoldet. Da der thermische Ausdehnungskoeffizient sehr nahe an dem des Leadframes 10 ist, ist eine Beschädigung der Verbindungsstellen für die Bestückkomponenten vernachlässigbar. Die Verbindungstechnik für die Komponenten kann insbesondere Kleben, Löten und Bonden sein.

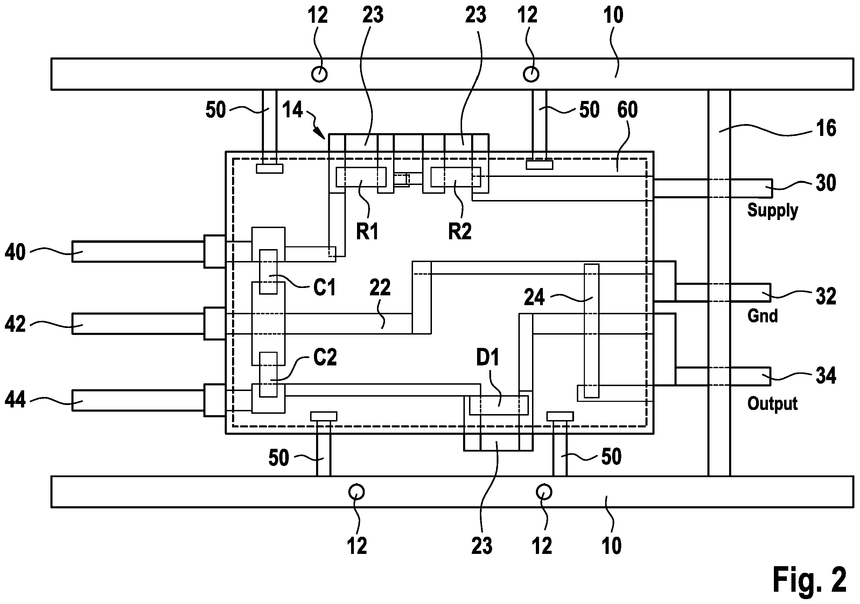

Figur 2 zeigt eine erste Variante nach dem Ausstanzen mit kurgeschlossenen, also unwirksamen, Komponenten R1, R2, D1 und der Terminal-Belegungsabfolge Supply, Gnd u. Output. Die Kurzschlüsse verbleiben, da die Kurzschlussstege 23 nicht mit ausgestanzt wurden. Der Dambar 14 ist partiell freigestanzt. Der Moldkörper 60 ist nur noch über die Support Pins bzw. Verbindungsstege 50 mit dem Leadframe 10 verbunden.

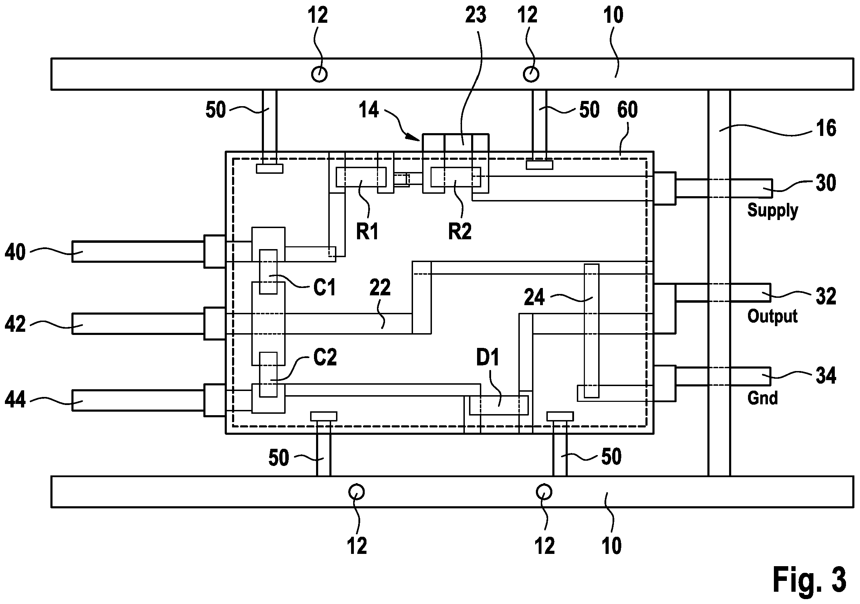

Figur 3 zeigt eine zweite Variante nach dem Ausstanzen, wobei die Komponenten C1, C2, R1 und D1 aktiv sind, da die jeweils zugehörigen Kurzschlussstege 23 ausgestanzt wurden. Der Kurzschlusssteg 23, welcher den zweiten Widerstand R2 kurzschließt, wurde hingegen nicht ausgestanzt. R2 ist also kurzgeschlossen und damit unwirksam. Die Terminal-Belegung ist hier Supply, Output, Gnd.

Wie aus den Figuren 2 und 3 ersichtlich ist kann durch entsprechendes selektives Ausstanzen von Teilen der rechtsseitigen Dambar 14 auch die Belegung der Eingangsterminals 30, 32, 34 festgelegt werden.

In allen hier gezeigten Figuren können die elektrischen Verbindungen zwischen den Eingangsanschlüssen 30, 32, 34 und den Ausgangsanschlüssen 40, 42, 44 leicht nachvollzogen werden, indem die jeweiligen möglichen Strompfade verfolgt werden.

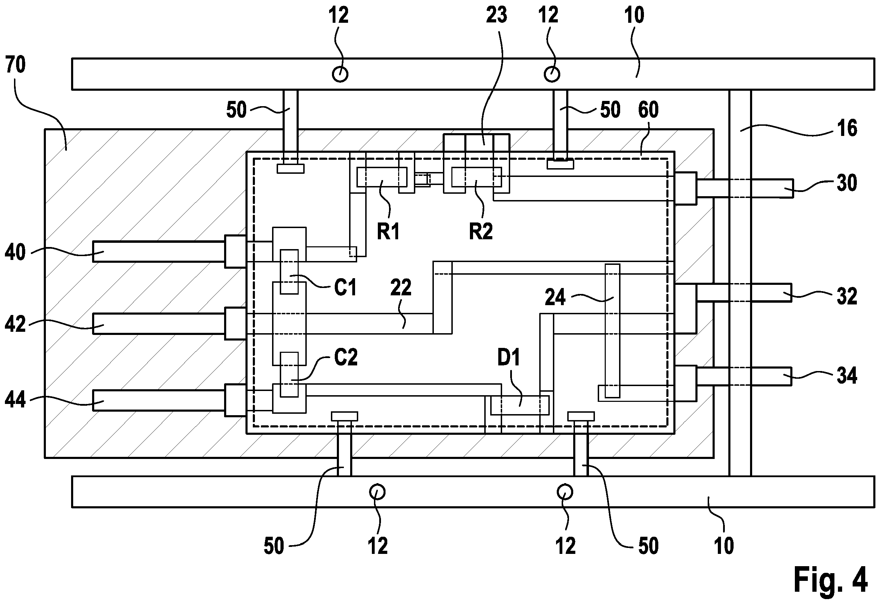

Figur 4 zeigt einen Zustand, in welchem nach dem Zustand von Figur 3 zum weiteren Schutz und um ein Neutralteil zu erhalten der partiell freigestanzte Moldkörper 60 mit einem weiteren Moldkörper 70 in Form einer weiteren Kunststoffhülle umgeben wurde. Bevorzugt ist hier Duroplast. Aber auch Thermoplaste können verwendet werden. Die Support Pins bzw. Verbindungsstege 50 dienen hier insbesondere für eine reproduzierbare, lagegenaue Positionierung während des zweiten Moldvorganges.

Der zweite Moldkörper 70 kann auch den bestückten oder verbundenen Sensor vollständig oder partiell umschließen.

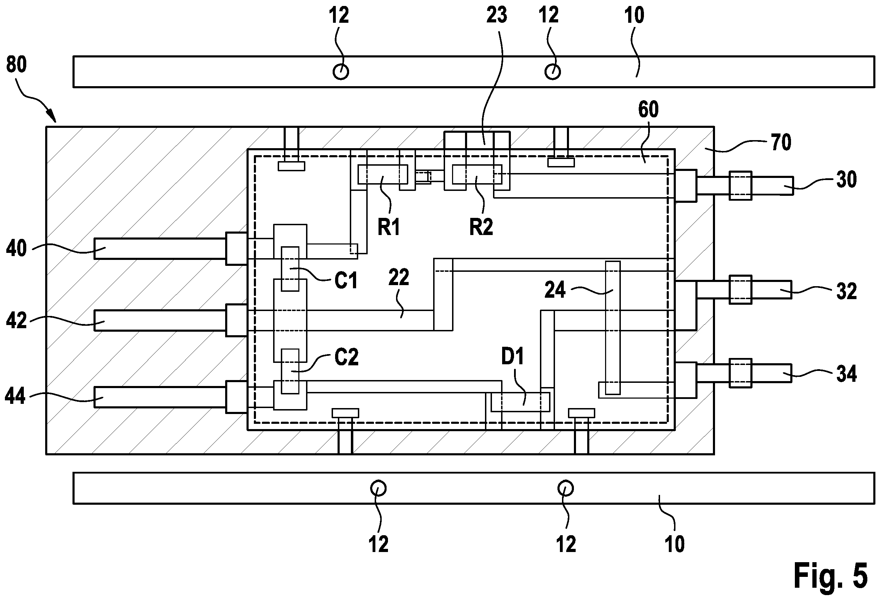

Figur 5 zeigt einen Zustand nach einem finalen Freistanzen bzw. Vereinzeln ausgehend von dem in Figur 4 gezeigten Zustand. Damit liegt ein Neutralteil vor, welches vom verbleibenden Leadframe 10 getrennt ist. Das Neutralteil kann in weiteren Prozessschritten mit einem nicht dargestellten kundenspezifischen Moldkörper verbunden oder umschlossen werden. Es stellt ein erfindungsgemäßes Verbindungselement 80 dar, welches mittels des erfindungsgemäßen Verfahrens hergestellt wurde.

Erwähnte Schritte des erfindungsgemäßen Verfahrens können in der angegebenen Reihenfolge ausgeführt werden. Sie können jedoch auch in einer anderen Reihenfolge ausgeführt werden. Das erfindungsgemäße Verfahren kann in einer seiner Ausführungen, beispielsweise mit einer bestimmten Zusammenstellung von Schritten, in der Weise ausgeführt werden dass keine weiteren Schritte ausgeführt werden. Es können jedoch grundsätzlich auch weitere Schritte ausgeführt werden, auch solche welche nicht erwähnt sind.

## Patentansprüche

1. Verfahren zum Herstellen eines Verbindungselements (80), wobei das Verbindungselement zum selektiven Herstellen elektrischer Verbindungen zwischen einer Anzahl von Eingangsanschlüssen (30, 32, 34) und einer Anzahl von Ausgangsanschlüssen (40, 42, 44) dient,
wobei das Verfahren folgende Schritte aufweist:
- Bereitstellen eines Leadframes (10), wobei in dem Leadframe (10) zumindest ein Ausgangselement (20) angeordnet ist, welches eine Anzahl von elektrisch leitenden Stegen (22) aufweist, und
- selektives Ausstanzen einer Anzahl von Stegen (22) aus dem Ausgangselement (20), so dass eine Anzahl von elektrischen Verbindungen zwischen Eingangsanschlüssen (30, 32, 34) und Ausgangsanschlüssen (40, 42, 44) verbleiben, **dadurch gekennzeichnet, dass**
das Verfahren vor oder nach dem Schritt des Ausstanzens einen Schritt des Umhüllens der Stege (22) oder zumindest eines Teils der Stege (22) und vorzugsweise auch von Bauelementen (C1, C2, R1, R2, D1) mit einem Moldkörper (60) aufweist.

2. Verfahren nach Anspruch 1,
- wobei das Ausgangselement (20) eine Anzahl von Bauelementen (C1, C2, R1, R2, D1) aufweist, welche mittels der Stege (22) elektrisch kontaktiert sind.

3. Verfahren nach Anspruch 2,
- wobei die Bauelemente (C1, C2, R1, R2, D1) ausgewählt sind aus der Gruppe, welche folgende Bauelemente aufweist:
- Kondensatoren,
- Widerstände,
- Jumper,
- Dioden,
- passive Bauelemente,
- aktive Bauelemente.

4. Verfahren nach einem der Ansprüche 2 oder 3,
- wobei eine Anzahl der Bauelemente (C1, C2, R1, R2, D1) vor dem Schritt des Ausstanzens mittels zumindest eines jeweiligen Kurzschlussstegs kurzgeschlossen sind.

5. Verfahren nach Anspruch 4,
- wobei eine Anzahl der Kurzschlussstege beim Schritt des Ausstanzens ausgestanzt werden.

6. Verfahren nach Anspruch 4 oder 5,
- wobei eine Anzahl der Kurzschlussstege beim Schritt des Ausstanzens nicht ausgestanzt werden.

7. Verfahren nach einem der vorhergehenden Ansprüche,
- wobei der Leadframe (10) eine Anzahl von Dambars (14) aufweist.

8. Verfahren nach einem der vorhergehenden Ansprüche,
- wobei der Moldkörper (60) zumindest teilweise durch die Dambars (14) begrenzt wird.

9. Verfahren nach Anspruch 8,
- wobei die Dambars (14) beim Schritt des Ausstanzens entfernt werden.

10. Verfahren nach einem der vorhergehenden Ansprüche,
- wobei der Leadframe (10) eine Anzahl von Support-Pins (50) zum Halten des Moldkörpers (60) aufweist.

11. Verfahren nach einem der vorhergehenden Ansprüche,
- welches nach dem Schritt des Umhüllens mit einem Moldkörper (60) einen Schritt des Umhüllens des Moldkörpers mit einem weiteren Moldkörper (70) aufweist, wobei für den weiteren Moldkörper (70) vorzugsweise ein anderes Material verwendet wird als für den Moldkörper (60).

12. Verfahren nach einem der vorhergehenden Ansprüche,
- wobei beim Schritt des Ausstanzens eine jeweilige Zuordnung von Eingangsanschlüssen (30, 32, 34) und/oder Ausgangsanschlüssen (40, 42, 44) zu vorgegebenen Belegungen, insbesondere Versorgungsspannung, Masse und Ausgang, erfolgt.

## Claims

1. Method for producing a connecting element (80), wherein the connecting element serves for selectively producing electrical connections between a number of input terminals (30, 32, 34) and a number of output terminals (40, 42, 44),
wherein the method comprises the following steps:
- providing a leadframe (10), wherein at least one output element (20) is arranged in the leadframe (10), said output element having a number of electrically conductive webs (22), and
- selectively stamping out a number of webs (22) from the output element (20) with the result that a number of electrical connections between the input terminals (30, 32, 34) and the output terminals (40, 42, 44) remain, **characterized in that** the method has, before or after the stamping-out step, a step of encasing the webs (22) or at least some of the webs (22) and preferably also components (C1, C2, R1, R2, D1) with a molded body (60).

2. Method according to Claim 1,
- wherein the output element (20) has a number of components (C1, C2, R1, R2, D1), which are electrically contact-connected by means of the webs (22).

3. Method according to Claim 2,
- wherein the components (C1, C2, R1, R2, D1) are selected from the group comprising the following components:
- capacitors,
- resistors,
- jumpers,
- diodes,
- passive components,
- active components.

4. Method according to either of Claims 2 and 3,
- wherein a number of the components (C1, C2, R1, R2, D1) are shorted by means of at least one respective shorting web before the stamping-out step.

5. Method according to Claim 4,
- wherein a number of the shorting webs are stamped out in the stamping-out step.

6. Method according to Claim 4 or 5,
- wherein a number of the shorting webs are not stamped out in the stamping-out step.

7. Method according to one of the preceding claims,
- wherein the leadframe (10) has a number of dam bars (14) .

8. Method according to one of the preceding claims,
- wherein the molded body (60) is at least partly limited by the dam bars (14).

9. Method according to Claim 8,
- wherein the dam bars (14) are removed in the stamping-out step.

10. Method according to one of the preceding claims,
- wherein the leadframe (10) has a number of support pins (50) for holding the molded body (60).

11. Method according to one of the preceding claims,
- which has, after the step of encasing with a molded body (60), a step of encasing the molded body with a further molded body (70), wherein a different material is preferably used for the further molded body (70) than for the molded body (60).

12. Method according to one of the preceding claims,
- wherein, in the stamping-out step, input terminals (30, 32, 34) and/or output terminals (40, 42, 44) are respectively associated with predefined allocations, in particular supply voltage, ground and output.

## Revendications

1. Procédé de fabrication d'un élément de liaison (80), l'élément de liaison servant à établir sélectivement des liaisons électriques entre une pluralité de bornes d'entrée (30, 32, 34) et une pluralité de bornes de sortie (40, 42, 44),
le procédé comprenant les étapes suivantes :
- fourniture d'une grille de connexion (10), au moins un élément initial (20) qui possède une pluralité d'éléments jointifs (22) électriquement conducteurs étant disposé dans la grille de connexion (10), et
- découpage sélectif à la matrice d'une pluralité d'éléments jointifs (22) à partir de l'élément initial (20), de sorte qu'il reste une pluralité de liaisons électriques entre les bornes d'entrée (30, 32, 34) et les bornes de sortie (40, 42, 44), **caractérisé en ce que** le procédé comprend, avant ou après l'étape de découpage à la matrice, une étape d'enrobage des éléments jointifs (22) ou d'au moins une partie des éléments jointifs (22) et de préférence aussi de composants (C1, C2, R1, R2, D1) avec un corps de moulage (60).

2. Procédé selon la revendication 1,
- l'élément initial (20) possédant une pluralité de composants (C1, C2, R1, R2, D1) avec lesquels le contact est établi électriquement au moyen des éléments jointifs (22) .

3. Procédé selon la revendication 2,
- les composants (C1, C2, R1, R2, D1) étant choisis dans le groupe qui comprend les composants suivants :
- condensateurs,
- résistances,
- cavaliers,
- diodes,
- composants passifs,
- composants actifs.

4. Procédé selon l'une des revendications 2 ou 3,
- une pluralité des composants (C1, C2, R1, R2, D1) étant court-circuités au moyen d'au moins un élément jointif de court-circuit respectif avant l'étape de découpage à la matrice.

5. Procédé selon la revendication 4,
- une pluralité des éléments jointifs de court-circuit étant découpés à la matrice lors de l'étape de découpage à la matrice.

6. Procédé selon la revendication 4 ou 5,
- une pluralité des éléments jointifs de court-circuit n'étant pas découpés à la matrice lors de l'étape de découpage à la matrice.

7. Procédé selon l'une des revendications précédentes,
- la grille de connexion (10) possédant une pluralité de tiges d'arrêt (14) .

8. Procédé selon l'une des revendications précédentes,
- le corps de moulage (60) étant au moins partiellement délimité par les tiges d'arrêt (14).

9. Procédé selon la revendication 8,
- les tiges d'arrêt (14) étant retirées lors de l'étape de découpage à la matrice.

10. Procédé selon l'une des revendications précédentes,
- la grille de connexion (10) possédant une pluralité de broches support (50) destinées à maintenir le corps de moulage (60).

11. Procédé selon l'une des revendications précédentes,
- lequel comprend, après l'étape d'enrobage avec un corps de moulage (60), une étape d'enrobage du corps de moulage avec un corps de moulage supplémentaire (70), un matériau différent de celui du corps de moulage (60) étant de préférence utilisé pour le corps de moulage supplémentaire (70).

12. Procédé selon l'une des revendications précédentes,
- une association respective des bornes d'entrée (30, 32, 34) et/ou des bornes de sortie (40, 42, 44) à des affectations prédéfinies, notamment une tension d'alimentation, une masse et une sortie, étant effectuée lors de l'étape de découpage à la matrice.
